# EUROPÄISCHE PATENTSCHRIFT

(11) **EP 4 259 437 B1**
(45) Veröffentlichungstag und Bekanntmachung des Hinweises auf die Patenterteilung: **05.02.2025**
(21) Anmeldenummer: 21835975.0
(22) Anmeldetag: 02.12.2021
(51) Int. Cl.: B41F 15/46, H05K 3/12, B41F 15/08

(54) **RAKELWERK FÜR EINE DRUCKVORRICHTUNG**
DOCTORING UNIT FOR A PRINTING APPARATUS
MÉCANISME DE RACLAGE POUR DISPOSITIF D'IMPRESSION

(30) Priorität: 09.12.2020 DE 102020215577
(43) Veröffentlichungstag der Anmeldung: 18.10.2023
(73) Patentinhaber: Ekra Automatisierungssysteme GmbH, 74357 Bönnigheim (DE)
(72) Erfinder: VEGELAHN, Torsten, 75447 Sternenfels (DE)
(74) Vertreter: Clarenbach, Carl-Philipp
(86) Internationale Anmeldenummer: PCT/EP2021/083995
(87) Internationale Veröffentlichungsnummer: WO 2022/122551

(56) Entgegenhaltungen:
- DE-A1- 19 624 442
- KR-A- 20190 052 775
- US-A1- 2001 017 086

## Beschreibung

Die Erfindung betrifft ein Rakelwerk für eine Druckvorrichtung zum Bedrucken von flächigen Substraten, insbesondere Leiterplatten, Wafer oder Solarzellen, mit zwei Rakelklingen, die sich parallel zueinander erstrecken und verschwenkbar gelagert sind.

Weiterhin betrifft die Erfindung eine Rakelvorrichtung für eine Druckvorrichtung zum Bedrucken von flächigen Substraten, insbesondere Leiterplatten, Wafer oder Solarzellen, mit einem Rakelwerk und mit einer Antriebseinrichtung zum Betreiben des Rakelwerks.

Weiterhin betrifft die Erfindung eine Druckvorrichtung zum Bedrucken von flächigen Substraten, insbesondere Leiterplatten, Wafer oder Solarzellen, mit einer Rakelvorrichtung, mit einem Drucksiebhalter, an welchem ein Drucksieb oder eine Druckmaske anordenbar oder angeordnet ist, und mit einem Drucktisch, auf welchem das zu bedruckende Substrat auf der von der Rakelvorrichtung abgewandten Seite des Drucksiebhalters anordenbar ist.

Druckvorrichtungen und Rakelwerke der eingangs genannten Art sind aus dem Stand der Technik bereits bekannt. Zum Bedrucken von flächigen Substraten wie Leiterplatten oder Wafern werden Rakelwerke eingesetzt, durch welche das Aufdrucken vorbestimmter Muster, beispielsweise Leiterbahnen oder dergleichen, in hoher Stückzahl in kurzer Zeitdauer möglich ist. Dazu wird auf ein Drucksieb oder eine Druckmaske die Druckmasse gegeben, die beispielsweise auch aus einem elektrisch leitfähigen Material gefertigt sein kann, wobei die Druckmaske oder das Drucksieb Öffnungen oder Freiräume aufweist, die dem gewünschten Druckbild entsprechen. Wird anschließend das Rakel mit einer oder mehreren Rakelklingen über das Sieb verschoben, so wird dadurch die Druckmasse durch das Drucksieb oder die Druckmaske oder Druckschablone hindurch gedrückt und damit auf das Substrat aufgebracht. Es sind Rakelwerke bekannt, die zwei Rakelklingen aufweisen, die sich parallel zueinander erstrecken, jedoch gegenläufig zueinander geneigt ausgerichtet sind, sodass die eine Rakelklinge beim Verschieben in eine erste Richtung mit der Druckmasse zusammenwirkt, und die zweite Rakelklinge beim Verschieben der Rakelklingen in die entgegengesetzte Richtung.

Aus der Offenlegungsschrift KR 2019 0052775 A ist beispielsweise ein gattungsgemäßes Rakelwerk bekannt, das zwei unabhängig voneinander bewegbare Rakel aufweist.

Um einen Druckmassenwechsel vorzunehmen, muss das Rakelwerk von der bisher verwendeten Druckmasse befreit beziehungsweise gereinigt werden. Dazu werden beispielsweise die Rakelklingen sowie das Drucksieb oder die Druckmaske aus dem Rakelwerk entnommen und außerhalb der Druckvorrichtung gereinigt. Sowohl bei der Entnahme als auch beim Transport des Rakelwerks kann Druckmasse verloren gehen, die nach dem zuvor erfolgten Druckvorgang an den Rakelklingen verblieben ist. Spätestens in der Reinigung geht die Druckmasse dann für weitere Druckvorgänge verloren.

Der Erfindung liegt die Aufgabe zugrunde, ein verbessertes Rakelwerk zu schaffen, bei dem ein Druckmassenverlust beim Austausch des Rakelwerks oder der Druckmasse reduziert wird.

Die der Erfindung zugrundeliegende Aufgabe wird durch ein Rakelwerk mit den Merkmalen des Anspruchs 1 gelöst. Das erfindungsgemäße Rakelwerk hat den Vorteil, dass auch eine größere Menge von Druckmasse mit dem Rakelwerk sicher aufbewahrt oder transportiert werden kann, insbesondere auch dann, wenn das gesamte Rakelwerk von der Druckvorrichtung gelöst wird. Durch die Erfindung wird erreicht, dass Druckmasse in dem Rakelwerk sicher gehalten wird und beispielsweise gezielt einer Wiederverwendung zugeführt werden kann. Die Erfindung erlaubt es außerdem, das Rakelwerk von einer Druckvorrichtung zu einer anderen Druckvorrichtung zu überführen und dabei Druckmasse, insbesondere Lotpaste, von einem Drucksieb zu einem anderen Drucksieb, auch einer anderen Druckvorrichtung, zu übertragen. Dadurch spart der Anwender Materialkosten, vermeidet Abfall und reduziert den Anteil an in der Fertigung umlaufenden Rakelwerken. Ist das Rakelwerk außerdem vollautomatisch austauschbar, ergibt sich ein höherer Automatisierungsgrad in der Fertigung.

Erfindungsgemäß wird dies dadurch erreicht, dass die Rakelklingen verschwenkbar gelagert sind, insbesondere gegenläufig verschwenkbar, sodass der Rakelklingenwinkel in Bezug zu dem Drucksieb oder der Druckmaske einstellbar ist, und dass die Rakelklingen mit einem Getriebe wirkverbunden sind, das selbsthemmend ausgebildet und mit einer Antriebseinrichtung koppelbar oder gekoppelt ist. Durch das Getriebe ist somit der Rakelwinkel mithilfe der Antriebseinrichtung einstellbar. Dadurch, dass die Rakelklingen durch das Getriebe bevorzugt auch miteinander wirkverbunden sind, erfolgt eine Einstellung des Rakelwinkels beider Rakelklingen gleichzeitig durch dasselbe Getriebe und dieselbe Antriebseinrichtung. Dadurch, dass das Getriebe selbsthemmend ausgebildet ist, behalten die Rakelklingen den einmal eingestellten Rakelwinkel bei, insbesondere auch dann, wenn die Antriebseinrichtung von dem Getriebe abgekoppelt ist. Dadurch sind die Rakelklingen insbesondere in eine Transportstellung verschwenkbar, in welcher die Druckmasse optimal zurückgehalten beziehungsweise in dem Rakelwerk behalten wird, um einen Austausch des Rakelwerks oder ein Verbringen des Rakelwerks zu einer Reinigungseinrichtung ohne Druckmassenverlust zu bewerkstelligen.

Besonders bevorzugt sind die Rakelklingen derart an dem Rakelrahmen angeordnet und das Getriebe derart ausgebildet, dass die Rakelklingen durch das Getriebe in eine V-förmige Stellung verschwenkbar sind, in welcher die Rakelklingen an ihren freien Rakelwirkkanten aneinander anliegen. Unter den Rakelwirkkanten werden hierbei die Längskanten der Rakelklingen verstanden, die im Betrieb dem Drucksieb oder Druckmaske zugeordnet sind und die Druckmasse durch die Druckmaske oder das Drucksieb pressen. Durch das Verschwenken in die V-förmige Stellung schließen die Rakelklingen zusammen einen V-förmigen Raum ein, der an seinem spitzen Ende durch das Aneinanderliegen der Rakelwirkkanten verschlossen ist. Auf den Rakelklingen befindliche Druckmasse kann somit nicht aus diesem Raum im Bereich der Rakelwirkkanten entweichen. Es wird somit eine Art der Druckmassentasche in dem Rakelwerk gebildet, mithilfe welcher die Druckmasse sicher zurückgehalten werden kann, um beispielsweise einen Schablonen- oder Siebwechsel durchzuführen oder um das Rakelwerk insgesamt auszutauschen.

Erfindungsgemäß ist das Getriebe als Schneckenradgetriebe ausgebildet. Hierdurch kann die Selbsthemmung des Getriebes auf einfache und bekannte Art und Weise sicher und kostengünstig realisiert werden. Durch das Schneckenradgetriebe können hohe Stellkräfte übertragen werden und es wird eine hohe Robustheit gegen ungewolltes Verstellen der Rakelwinkel gewährleistet.

Vorzugsweise ist dabei jede Rakelklinge an jeweils einer drehbar gelagerten Welle zum Verschwenken angeordnet, wobei auf jeder der Wellen ein Schneckenrad des Schneckenradgetriebes drehfest angeordnet ist, das in Eingriff mit einer mit dem Antrieb verbundenen oder verbindbaren Schneckenwelle des Schneckenradgetriebes steht. Dadurch sind die Rakelklingen mithilfe des Getriebes verstellbar. Ein Verstellen der Rakelklingen, ohne dass die Schneckenwelle angetrieben wird, ist jedoch durch die Selbsthemmung verhindert. Die Wellen sind vorzugsweise in die jeweilige Rakelklinge integral ausgebildet, sodass die Rakelklingen beispielsweise an ihren von der Rakelwirkkante abgewandten Längsseiten die jeweilige Welle selbst mitausbilden, wozu beispielsweise an den Stirnseiten der jeweiligen Rakelklinge Wellenstummel vorstehen, die in eine Lageraufnahme beispielsweise des Lagerrahmens zur verschwenkbaren Lagerung einsetzbar sind. So ist es auch denkbar, dass das jeweilige Schneckenrad einstückig mit der jeweiligen Rakelklinge ausgebildet ist und soweit kein vollständiges Schneckenrad ausbildet, sondern ein Schneckenrad, das sich über weniger als 360° im Umfang erstreckt. Gemäß einer alternativen Ausführungsform der Erfindung ist die jeweilige Rakelklinge auf eine durchgehende Welle aufgeschoben und entweder verdrehbar auf der Welle gelagert, oder die Welle ist verdrehbar in der Lageraufnahme beispielsweise des Rakelrahmens gelagert. Das Schneckenrad ist in diesem Fall dann entweder drehfest mit der Rakelklinge und/oder drehfest mit der Welle verbunden.

Weiterhin ist bevorzugt vorgesehen, dass das Getriebe eine Antriebswelle aufweist, die einerseits mit der Schneckenwelle gekoppelt ist und andererseits ein Koppelende aufweist, das zur lösbaren Kopplung der Antriebswelle mit der Antriebseinrichtung ausgebildet ist. Die Antriebswelle ist insbesondere drehfest mit der Schneckenwelle gekoppelt, sodass eine auf die Antriebswelle wirkende Antriebskraft, insbesondere ein Antriebsdrehmoment, direkt auf die Schneckenwelle ausgeübt wird, um die Rakelklingen zu verschwenken. Durch das Koppelende ist die Antriebswelle lösbar mit der Antriebseinrichtung verbindbar. Dadurch ist das Rakelwerk insgesamt in vorteilhafter Weise von der Antriebseinrichtung lösbar, wobei durch das Lösen die Selbsthemmung des Getriebes seine Wirkung entfaltet und ein weiteres Verstellen der Rakelklingen an den Rakelklingen selbst verhindert. Durch das Koppelende ist weiterhin ein einfaches Fügen oder Wirkverbinden des Rakelwerks mit der Antriebseinrichtung gewährleistet.

Besonders bevorzugt ist das Koppelende als Bestandteil einer reibschlüssigen oder formschlüssigen lösbaren Kupplung ausgebildet, insbesondere als Bestandteil einer Reibkupplung oder Klauenkupplung. Durch die Reib- oder Klauenkupplung ist ein einfaches Fügen des Koppelendes mit der Antriebseinrichtung, die dann vorzugsweise ebenfalls eine Welle mit einem Bestandteil der Reibkupplung oder Klauenkupplung beziehungsweise der reibschlüssigen oder formschlüssigen Kupplung aufweist, gewährleistet.

Gemäß einer bevorzugten Weiterbildung der Erfindung weist das Rakelwerk ein Gehäuse auf, in oder an welchem das Getriebe, der Rakelträger und die Rakelklingen gehalten sind, wobei die Antriebswelle durch eine Öffnung des Gehäuses nach außen geführt ist. Durch das Gehäuse werden zum einen die in dem Gehäuse angeordneten Bestandteile des Rakelwerks, wie das Getriebe, der Rakelträger und die Rakelklingen vor äußeren Einflüssen geschützt. Dadurch, dass die Antriebswelle von dem Gehäuse vorsteht, ist eine einfache Kopplung mit der Antriebseinrichtung gewährleistet. Darüber hinaus ist zum anderen die von dem Gehäuse vorstehende Antriebswelle auch durch einen Benutzer manuell betätigbar, um bei Bedarf die Position der Rakelklingen, beispielsweise zu Reinigungszwecken, zu verändern. So kann das Rakelwerk beispielsweise außerhalb der Druckvorrichtung von einem Anwender manuell oder durch eine Reinigungsmaschine automatisiert betätigt werden, um die durch die Rakelklingen gebildete Aufnahmetasche zu öffnen und die darin enthaltene Druckmasse freizugeben.

Gemäß einer bevorzugten Weiterbildung der Erfindung weist das Rakelwerk Mittel zur lösbaren Befestigung des Rakelwerks an der Antriebseinrichtung auf. Durch die Mittel ist somit das Rakelwerk lösbar an der Antriebseinrichtung befestigbar, wodurch ein einfacher Austausch des Rakelwerks einer Druckvorrichtung beziehungsweise an der Antriebseinrichtung ermöglicht ist. Somit ist das gesamte Rakelwerk einfach von der Antriebseinrichtung lösbar und beispielsweise zu einer anderen Druckvorrichtung mit entsprechender Antriebseinrichtung verbringbar und dort mit der Antriebseinrichtung verbindbar, um einen weiteren Druckvorgang an der anderen Druckvorrichtung durchzuführen. Auch kann das Rakelwerk losgelöst von der Antriebseinrichtung und entsprechend der Druckvorrichtung einer Reinigungseinrichtung zugeführt werden. Unter Mittel zur lösbaren Befestigung werden insbesondere Mittel verstanden, die mit wenigen Handgriffen ein insbesondere werkzeugfreies Lösen oder Befestigen des Rakelwerks an der Antriebseinrichtung erlauben. Eine Schraubverbindung, bei welcher das Rakelwerk durch eine Befestigungsschraube an der Antriebseinrichtung befestigbar wäre, wird in diesem Zusammenhang nicht als Mittel zur lösbaren Befestigung, sondern als dauerhaftes Befestigungsmittel verstanden.

Besonders bevorzugt ist das Mittel als Rastmittel ausgebildet. Dadurch ist das Rakelwerk an der Antriebseinrichtung durch Verrastung formschlüssig arretierbar. Das Rastmittel weist bevorzugt ein oder mehrere elastisch verlagerbare Rastelemente auf, die unter elastischer Verformung in eine das Rakelwerk formschlüssig an der Antriebseinrichtung haltende Position verbringbar sind. Vorzugsweise weisen die Mittel außerdem Vertiefungen oder Einkerbungen auf, beispielsweise in dem Gehäuse oder der Antriebseinrichtung ausgebildet, um mit jeweils einem elastisch verlagerbaren Rastelement der Antriebseinrichtung formschlüssig oder des Gehäuses zusammenzuwirken. Das jeweilige elastisch verlagerbare oder verformbare Rastelement kann also an dem Rakelwerk selbst oder an der Antriebseinrichtung angeordnet sein. Die Vertiefung oder Einkerbung ist dann an der jeweils anderen Einrichtung angeordnet oder ausgebildet.

Gemäß einer bevorzugten Weiterbildung der Erfindung weist das Rakelwerk eine Antriebseinrichtung auf, die zumindest eine Antriebsmaschine, insbesondere Elektromaschine, aufweist, die mit dem Getriebe, insbesondere mit der Antriebswelle des Getriebes koppelbar oder gekoppelt ist. Bei der Antriebseinrichtung handelt es sich insbesondere um die zuvor beschriebene Antriebseinrichtung, mit welcher das übrige Rakelwerk lösbar verbindbar ist. Optional ist die Antriebseinrichtung in eine Druckeinrichtung integriert, die insbesondere außerdem einen Drucktisch aufweist, auf welchem das zu bedruckende Substrat anordenbar ist.

Die Antriebsmaschine weist bevorzugt eine Abtriebswelle auf, die ein mit dem Getriebe gekoppeltes oder koppelbares Ende aufweist. Das Ende der Abtriebswelle ist somit mit dem Koppelende der Antriebswelle lösbar verbindbar. Insbesondere bilden das Koppelende und das Ende zusammen eine formschlüssig arbeitende oder eine reibschlüssig arbeitende Kupplung, insbesondere eine Klauenkupplung oder eine Reibkupplung aus.

Die erfindungsgemäße Rakelvorrichtung mit den Merkmalen des Anspruchs 7 zeichnet sich durch die erfindungsgemäße Ausbildung des Rakelwerks aus. Es ergeben sich hierdurch die zuvor genannten Vorteile. Weitere Vorteile und bevorzugte Merkmale und Merkmalskombinationen ergeben sich insbesondere aus dem zuvor Beschriebenen sowie aus den Ansprüchen.

Insbesondere ist das Rakelwerk lösbar mit der Antriebseinrichtung gekoppelt oder koppelbar. Insbesondere weisen die Antriebseinrichtung und/oder das Rakelwerk die oben genannten Mittel zum einfachen Fügen und Lösen von Rakelwerk und Antriebseinrichtung auf, um einen einfachen Austausch des Rakelwerks zu gewährleisten. Insbesondere sind die Mittel, wie obenstehend beschrieben, als Rastmittel ausgebildet.

Besonders bevorzugt weist die Antriebseinrichtung einen Rakelwerkhalter auf, der lösbar mit dem Rakelwerk verbindbar ist. Insbesondere weist der Rakelwerkhalter die Mittel oder einen Teil der Mittel zur lösbaren Befestigung des Rakelwerks auf, sodass das Rakelwerk an dem Rahmenhalter lösbar befestigt oder befestigbar ist. Der Rakelwerkhalter stellt somit die Schnittstelle zwischen Rakelwerk und Antriebseinrichtung dar und dient zur Aufnahme und Lagerung des Rakelwerks. Die lösbare Verbindung ist insbesondere wie obenstehend beschrieben gestaltet, insbesondere mit zumindest einem elastisch verformbaren oder verlagerbaren Rastelement.

Der Rakelwerkhalter ist bevorzugt um eine sich parallel zu den Wellen des Rakelwerks ausgerichtete Mittelachse verschwenkbar gelagert. Durch das Verschwenken des Rakelwerkhalters um die Mittelachse erfolgt somit auch ein Verschwenken des an dem Rakelwerkhalters befestigten Rakelwerks, wodurch das Rakelwerk bei einem Druckvorgang optimal auf den durchzuführenden Druck in seiner Ausrichtung anpassbar ist. Insbesondere ist der Rakelwerkhalter in Abhängigkeit von der Richtung, in welcher die Rakelklingen verschoben werden, in die eine oder in die andere Richtung verschwenkt, um ein optimales Rakelergebnis zu erzielen.

Besonders bevorzugt ist dem Rakelwerkhalter an zumindest einem von der Mittelachse entfernten Vorsprung des Rakelwerkhalters ein ansteuerbarer Aktuator zum Verschwenken des Rakelwerkhalters zugeordnet. Der Rakelwerkhalter ist somit mittels des Aktuators in seiner Schwenkstellung beeinflussbar beziehungsweise einstellbar, um das präzise Druckergebnis zu erzielen. Optional weist der Rakelwerkhalter beidseits der Mittelachse entfernt angeordnete Vorsprünge auf, denen jeweils ein ansteuerbarer Aktuator zugeordnet ist.

Besonders bevorzugt ist der Aktuator als pneumatischer Aktuator mit einem dem Vorsprung zugeordneten Hubkolben ausgebildet, der insbesondere tangential zur Mittelachse auf den Vorsprung wirkt. Durch die Ausbildung des Aktuators als pneumatischer Aktuator erhält der Aktuator eine Elastizität durch das kompressible Pneumatikmedium. Dadurch ist sichergestellt, dass das Rakelwerk bei Auftreten einer überhöhten Widerstandskraft beim Verschieben der Rakelklingen entgegen der Kraft des Aktuators verschwenkbar oder bewegbar ist, sodass eine Beschädigung der Rakelklingen sicher vermieden wird. Der pneumatische Aktuator wirkt somit in der Art einer Vorspannung auf den Rakelrahmen. Insbesondere ist das gesamte Rakelwerk hierdurch verschwenkbar entgegen der Vorspannkraft des Aktuators verlagerbar.

Die erfindungsgemäße Druckvorrichtung mit den Merkmalen des Anspruchs 15 zeichnet sich durch die erfindungsgemäße Ausbildung der Rakelvorrichtung aus. Insbesondere ist das Rakelwerk austauschbar an der Antriebseinrichtung befestigt oder befestigbar, mit den oben genannten Mitteln. Das Rakelwerk bildet zusammen mit der Rakelvorrichtung insbesondere den Druckkopf der Druckvorrichtung aus. Vorzugsweise wird außerdem ein Drucksystem geschaffen, bei dem mehrere Druckvorrichtungen vorhanden sind, die jeweils eine Antriebseinrichtung aufweisen, an welcher das erfindungsgemäße Rakelwerk befestigbar ist.

Weitere Vorteile und bevorzugte Merkmale und Merkmalskombinationen ergeben sich insbesondere aus dem zuvor Beschriebenen sowie aus den Ansprüchen. Im Folgenden soll die Erfindung anhand der Zeichnungen näher erläutert werden. Dazu zeigen
- Figur 1: eine vorteilhafte Rakelvorrichtung für eine Druckvorrichtung in einer vereinfachten Seitenansicht,
- Figur 2: die Rakelvorrichtung in einer Draufsicht,
- Figur 3: eine Detailansicht der Rakelvorrichtung,
- Figuren 4A bis 4C: eine Hubvorrichtung der Rakelvorrichtung in unterschiedlichen Ansichten.

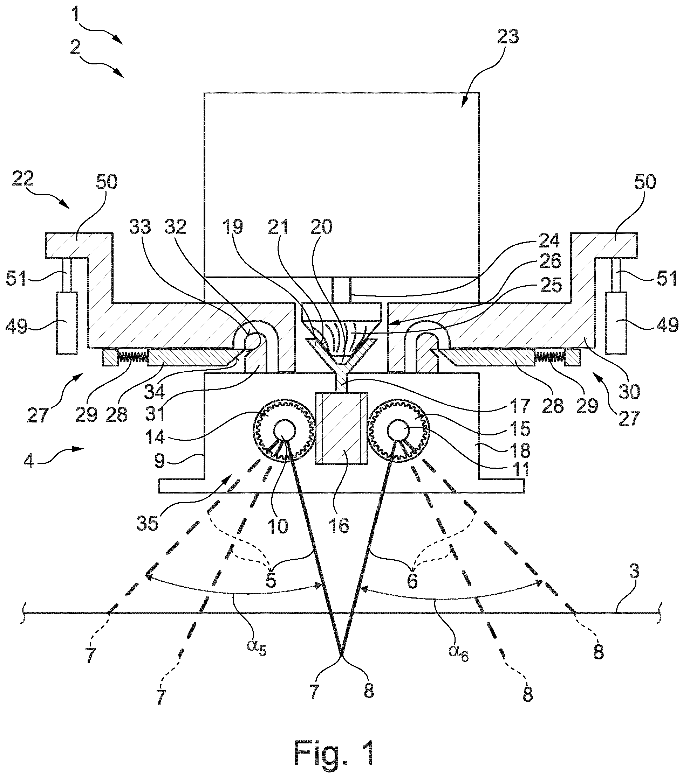

Figur 1 zeigt in einer vereinfachten Seitenansicht eine vorteilhafte Rakelvorrichtung 1 für eine hier nicht näher dargestellte Druckvorrichtung 2 zum Bedrucken von flächigen Substraten, insbesondere Leiterplatten, Wafern oder dergleichen. Die Rakelvorrichtung 1 ist dazu ausgebildet, Druckmasse durch Öffnungen oder Strukturen eines Drucksiebs 3, das in Figur 1 nur angedeutet ist, durchzupressen und damit auf ein oder mehrere unter dem Drucksieb 3 liegende Substrat aufzutragen.

Dazu weist die Rakelvorrichtung 1 ein Rakelwerk 4 auf, das zwei Rakelklingen 5, 6 trägt. In Figur 1 erstrecken sich die Rakelklingen 5, 6 senkrecht zur Bildebene, wobei die Rakelklingen 5, 6 jeweils mit einer Längskante an einem Rakelträger 9 des Rakelwerks 4 gehalten sind und an ihrer dieser Längskante abgewandten Längskante eine Rakelwirkkante 7, 8 ausbilden, die zum Überstreichen der Druckmasse beziehungsweise des Drucksiebs 3 dient. Die Rakelklingen 5, 6 können aus Metall oder Kunststoff gefertigt und steif oder leicht elastisch verformbar ausgebildet sein.

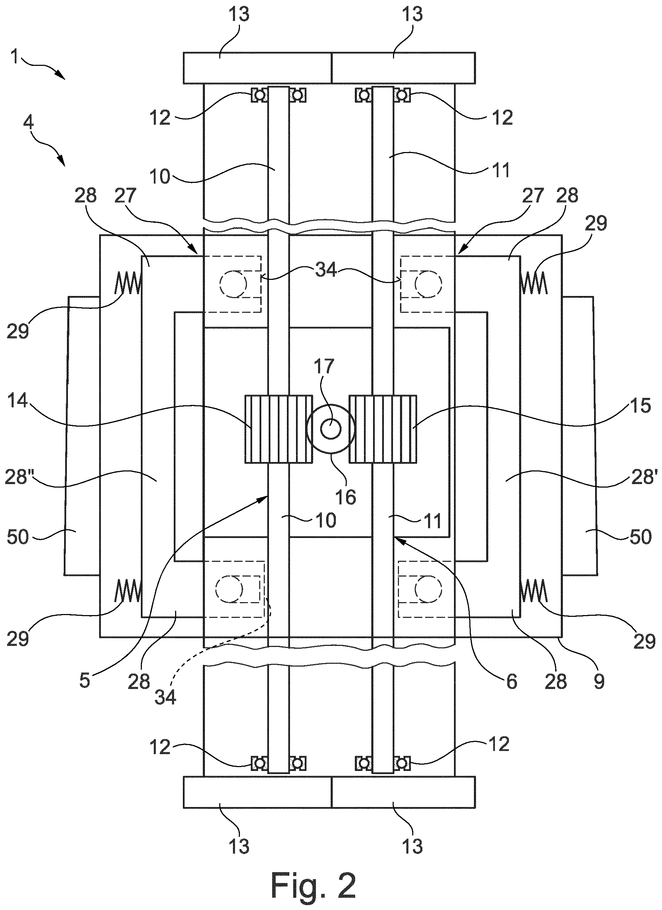

Figur 2 zeigt das Rakelwerk 4 in einer vereinfachten Draufsicht. Das Rakelwerk 4 weist den Rakelträger 9 auf, an welchem die Rakelklingen 5, 6 verschwenkbar gelagert sind. Dazu sind die Rakelklingen 5, 6 jeweils an ihrem von der Rakelwirkkante 7, 8 angewandten Ende jeweils mit einer drehbar gelagerten Welle 10, 11 verbunden beziehungsweise an dieser drehfest befestigt, sodass eine Drehung der jeweiligen Welle 11, 10 zu einer entsprechenden Verstellung des Rakelwinkels α₅ beziehungsweise α₆ der jeweiligen Rakelklinge 5, 6 führt, wie in Figur 1 gezeigt. Die Wellen 10, 11 weisen beispielsweise Radialschlitze auf, in welchen die Rakelklingen 5, 6 eingesteckt gehalten sind.

Wie in Figur 2 gezeigt, sind die Wellen 10, 11 vorteilhafterweise durch mehrere Wälzkörperlager 12 drehbar gelagert, sodass ein Verdrehen mit wenig Reibungsverlusten erfolgt. Optional sind den Rakelklingen 5, 6 stirnseitig Pastenbegrenzer 13 zugeordnet, die verhindern, dass beim Überstreichen des Drucksiebs 3 die aufgebrachte Druckpaste seitlich an den Rakelklingen 5, 6 vorbei entweicht.

Die Wellen 10, 11 tragen jeweils ein Schneckenrad 14, 15, das drehfest mit der jeweiligen Welle 5, 6 verbunden ist. Insbesondere sind die Schneckenräder 14, 15 mittig auf den Wellen 5, 6 - in Längserstreckung der Wellen 5, 6 gesehen - angeordnet, wie in Figur 2 gezeigt. Die Schneckenräder 14, 15 liegen somit parallel zueinander. Zwischen den Schneckenrädern 14, 15 ist eine Schneckenwelle 16 angeordnet, die mit den beiden Schneckenrädern 14, 15 kämmt beziehungsweise in Eingriff steht. Die Schneckenwelle 16 ist an dem Rakelträger 9 durch ein weiteres Wälzkörperlager 12 drehbar gelagert. Die Schneckenwelle 16 geht dazu in eine Antriebswelle 17 über, ist also einstückig mit dieser ausgebildet, die ein an dem Rakelträger 9 angeordnetes Gehäuse 18 im Bereich des Wälzkörperlagers durchdringt und von dem Gehäuse 18 nach außen vorsteht. Optional bildet der Rakelträger 9 das Gehäuse 18 aus. Das Gehäuse 18 ist wannenförmig ausgebildet, wie beispielhaft in Figur 1 gezeigt, wobei die Antriebswelle 17 den Boden der Wannenform durchdringt, und umgibt zumindest die Wellen 10, 11 sowie die Schneckenräder 14, 15, sodass diese vor äußeren Einflüssen geschützt sind. An seinen von der Antriebswelle 17 abgewandten Ende ist das Gehäuse 18 offen ausgebildet, sodass die Rakelklingen 5, 6 aus dem Gehäuse 18 austreten und verschwenkt werden können, wie in Figur 1 gezeigt.

Die Antriebswelle 17 weist an ihrem von der Schneckenwelle 16 abgewandten Ende ein Koppelende 19 auf. Das Koppelende 19 zeichnet sich dadurch aus, dass es einen mit zunehmendem Abstand von der Schneckenwelle 16 zunehmenden Außendurchmesser aufweist und an ihrer freien Stirnseite eine Vertiefung 20 aufweist, sodass das Koppelende 19 in der Art einer Hohlwelle ausgebildet ist, die sich im Längsschnitt gesehen V-förmig aufweitet. Damit ergibt sich eine Art Trichterform des Koppelendes 19. Vorteilhafterweise weist das Koppelende 19 an seiner Innenseite 21 eine Mitnahmestruktur, beispielsweise in Form von Riefen, Rillen, Vorsprüngen oder Zähnen auf. Gemäß einem alternativen Ausführungsbeispiel weist die Antriebswelle 17 zwar die Vertiefung 20 auf, weitet sich an ihrer Außenseite jedoch nicht auf, sodass stirnseitig eine insbesondere V-förmige Vertiefung 20 ausgebildet ist und die Mantelaußenwand der Welle im Bereich des Koppelendes 19 zylinderförmig verbleibt.

Die Rakelvorrichtung 1 weist weiterhin eine Antriebseinrichtung 22 auf, die oberhalb des Rakelwerks 4 angeordnet ist, wie in Figur 1 gezeigt. Die Antriebseinrichtung 22 weist beispielsweise einen Elektromotor 23 auf, der direkt oder durch ein Getriebe mit einer Abtriebswelle 24 verbunden ist. Die Abtriebswelle 24 ragt aus einem Gehäuse des Elektromotors 23 in Richtung des Rakelwerks 4 vor und weist ein Ende 25 auf, das dazu dient, lösbar mit dem Koppelende 19 des Rakelwerks 4 verbunden zu werden. Dazu ist das Ende 25 bevorzugt komplementär zu dem Koppelende 19 ausgebildet, gemäß dem vorliegenden Ausführungsbeispiel als Kegelstumpf, dessen Kegelwinkel in etwa dem Öffnungswinkel des V-förmigen Koppelendes 19 entspricht, vorzugsweise ist der Kegelstumpfwinkel geringfügig kleiner. Dadurch ist das Koppelende 19 einfach auf das Ende 25 der Abtriebswelle 24 aufschiebbar. Insbesondere bilden das Koppelende 19 zusammen mit dem Ende 25 eine lösbare Kupplung 26 aus. Insbesondere ist die Kupplung 26 als Reibkupplung ausgebildet. Alternativ ist die Kupplung 26 als Klauenkupplung oder formschlüssig wirkende Kupplung ausgebildet. Dazu dienen insbesondere die an der Innenseite 21 optional ausgebildeten Riefen, Zähne oder Rillen, die mit entsprechenden Vorsprüngen, Riefen, Rillen oder Zähne des Endes 25 in Eingriff gelangen. Dann ist eine formschlüssige Drehmomentübertragung von der Antriebseinrichtung 22 auf die Schneckenwelle 16 gewährleistet.

Gemäß einem weiteren Ausführungsbeispiel ist die Vertiefung 20 in dem Ende 25 ausgebildet und das Koppelende 19 weist einen dazu komplementären Kegelstumpf auf. Auch ist es denkbar, dass das Ende 25 und das Koppelende 19 beide jeweils eine flache Stirnseite in einer Ebene senkrecht zur Drehachse aufweisen, die beispielsweise zur Ausbildung der Reibkupplung aneinander gepresst sind oder ebenfalls eine Verzahnung zur formschlüssigen Drehmomentübertragung oder Drehmomentmitnahme aufweisen.

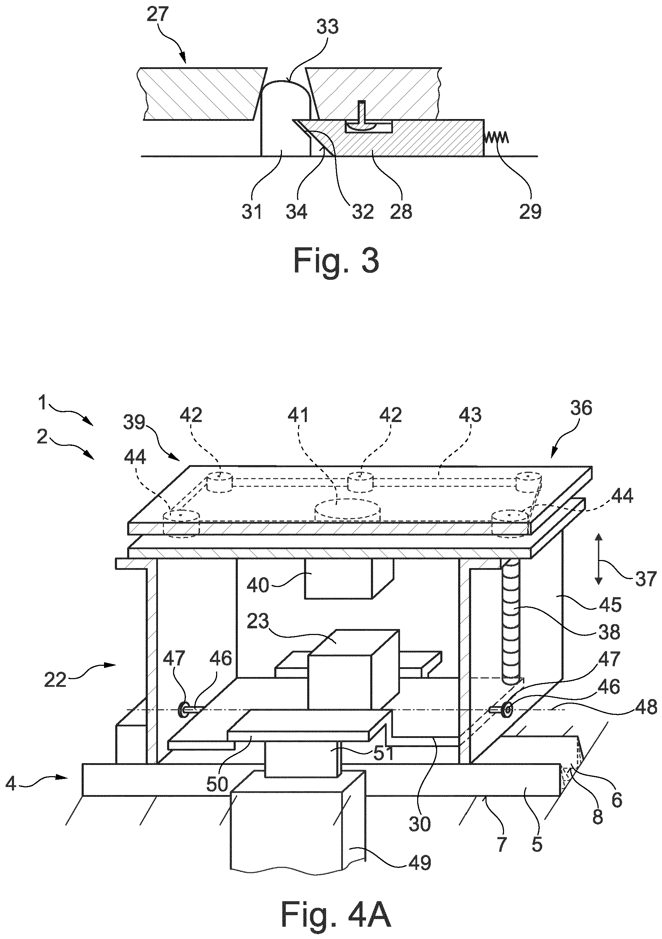

Durch die lösbare Kupplung 26 ist ein einfaches Entfernen des Rakelwerks 4 von der Antriebseinrichtung 22 möglich. Hierzu sind weiterhin Mittel 27 zur lösbaren Verbindung des Rakelwerks 4 mit der Antriebseinrichtung 2 vorhanden. Diese sollen mit Bezug auf Figuren 1 und 3 im Folgenden näher erläutert werden. Figur 3 zeigt dabei eine vergrößerte Detailansicht der Mittel 27.

Die Mittel 27 weisen vorliegend mehrere elastisch verlagerbare Rastelemente 28 auf. Gemäß dem vorliegenden Ausführungsbeispiel sind diese an der Antriebseinrichtung 22 angeordnet und seitlich verschiebbar gelagert beziehungsweise parallel zur Ebene des Drucksiebs 3. Die Rastelemente 28 sind in Form von Rastkeilen ausgebildet, die durch jeweils eine Vorspannfeder 29 in Richtung der Abtriebswelle 24 mit einer Federkraft beaufschlagt sind. Vorliegend sind zumindest zwei Rastelemente 28 einander gegenüberliegend an einem Rakelwerkhalter 30 der Antriebseinrichtung 22, an welchem das Rakelwerk 4 lösbar durch die Mittel 27 befestigt ist, gelagert.

Das Rakelwerk 4 weist eine der Anzahl der Rastelemente 28 entsprechende Anzahl von Gegenrastelementen 31 auf. Die Gegenrastelemente 31 sind beispielsweise in dem Rahmen und/oder dem Gehäuse 18 befestigt und ragen im Wesentlichen parallel zu der Antriebswelle 17 von dem Gehäuse 18 vor. Die Gegenrastelemente 31 weisen dabei jeweils eine seitliche Einkerbung 32 auf, wobei die Einkerbungen 32 der gegenüberliegenden Gegenrastelemente 31 voneinander abgewandt und damit dem jeweiligen Rastelement 28 zugewandt sind. Die Einkerbungen 32 sind derart groß ausgebildet, dass sie einen Abschnitt des jeweiligen Rastelements 28 aufnehmen können, wie insbesondere in Figur 3 gezeigt. Die Gegenrastelemente 31 weisen an ihren von dem Gehäuse 9 abgewandten Stirnseite eine Einführschräge 33 oder Anlaufschräge auf, durch welche das jeweilige Rastelement 28 beim Zuführen des Rakelwerks 4 zu der Antriebseinrichtung 22 entgegen der Kraft der Vorspannfeder 29 zurückgedrängt wird. Um das Verlagern zu erleichtern, weisen die Rastelemente 28 ebenfalls jeweils eine Anlaufschräge 34 oder Einführschräge auf, die mit der Einführschräge 33 des jeweiligen Rastelements 31 zusammenwirkt.

Wie Figur 2 zu entnehmen ist, sind jeweils zwei Rastelemente 28 vorliegend durch einen Quersteg 28` miteinander verbunden, sodass sich U-förmige Rastelemente ergeben.

Sobald das Gegenrastelement 33 beziehungsweise das Rakelwerk 4 ausreichend weit in Richtung der Antriebseinrichtung 22 geführt ist, sodass das Ende 25 und das Koppelende 19 miteinander in Wirkverbindung gelangen und das jeweilige Rastelement 28 vollständig auf Höhe der Einkerbung 32 liegt, wird das jeweilige Rastelement 28 durch die Federkraft der Vorspannfeder 29 in die jeweilige Kerbe eingeschoben. Dadurch ist das Rakelwerk 4 formschlüssig an der Antriebseinrichtung 22 gehalten und durch die Kupplung 26 mit dem Elektromotor 23 wirkverbunden. Zum Lösen des Rakelwerks 4 von der Antriebseinrichtung 22 werden die Rastelemente 28 entgegen der Kraft der jeweiligen Vorspannfeder 29 zurückgeschoben und damit aus der jeweiligen Einkerbung 33 entfernt, wonach das Rakelwerk 4 einfach von der Antriebseinrichtung 22 nach unten abziehbar ist. Die Wirkverbindung zwischen Koppelende 19 und Abtriebswelle 24 wird dabei ebenso ohne weitere Maßnahmen, insbesondere werkzeugfrei gelöst. Weil das aus Schneckenrädern 14, 15 und Schneckenwelle 16 gebildete Getriebe 35 selbsthemmend ist, verbleiben die Rakelklingen 5, 6 nach dem Entfernen des Rakelwerks 4 von der Antriebseinrichtung 22 in ihrer zuletzt eingestellten Schwenkposition. Die Schwenkposition kann an dem Rakelwerk 4 dann auch manuell von einem Anwender durch manuelles Aufbringen eines Drehmoments auf das Koppelende 19 verändert werden.

Vorteilhafterweise werden die Rakelklingen 5, 6 vor dem Lösen des Rakelwerks 4 von der Antriebseinrichtung 22 in eine Transportstellung verbracht, in welcher die Rakelklingen V-förmig zueinander geneigt angeordnet sind, sodass ihre freien Rakelkanten 7, 8 aneinander anliegen, wie in Figur 1 gezeigt. Figur 1 zeigt die Rakelklinge in der V-förmigen Transportposition mit durchgezogenen Linien und in weiteren beispielhaften Rakelpositionen mit gestrichelten Linien.

Durch die Selbsthemmung des Getriebes 35 ist gewährleistet, dass die Rakelklingen 5, 6 in der Transportposition verbleiben, sodass gegebenenfalls zwischen den Rakelklingen 5, 6 befindliche Druckmasse zwischen den Rakelklingen aufgenommen und aufbewahrt wird. Beim Transport des Rakelwerks 4 kann die Druckmasse den zwischen den Rakelklingen 5, 6 und den seitlichen Pastenbegrenzern 13 gebildeten Raum nicht verlassen. Dadurch ist ein sicherer Transport der Druckmasse beziehungsweise -paste gewährleistet, der es beispielsweise erlaubt, das Rakelwerk 4 ohne Druckmassenverluste von einem Drucktisch zu einem anderen Drucktisch zu verbringen oder von einem Drucktisch zu einer Reinigungseinrichtung, in welcher die noch vorhandene Druckmasse dann gezielt entfernt und zur Wiederverwendung aufbereitet werden kann. Dadurch wird der Verbrauch an Druckmasse insgesamt reduziert. Durch die lösbare Befestigung des Rakelwerks 4 an der Antriebseinrichtung 22, durch welche auch automatisch eine Wirkverbindung zwischen dem Getriebe 35 und der Antriebseinrichtung 22 entsteht, ist sowohl eine manuelle als auch eine automatisierte Anbringung des Rakelwerks 4 an der Antriebseinrichtung 22 sowie ein Lösen davon in kurzer Zeit und sicher durchführbar.

Figur 4A zeigt die Rakelvorrichtung 1 in einer vereinfachten perspektivischen Darstellung. In dieser Darstellung ist von der Druckvorrichtung 2 außerdem eine Hubvorrichtung 36 gezeigt, mittels welcher die Antriebseinrichtung insgesamt abgesenkt und angehoben werden kann, wie durch einen Doppelpfeil 37 gezeigt.

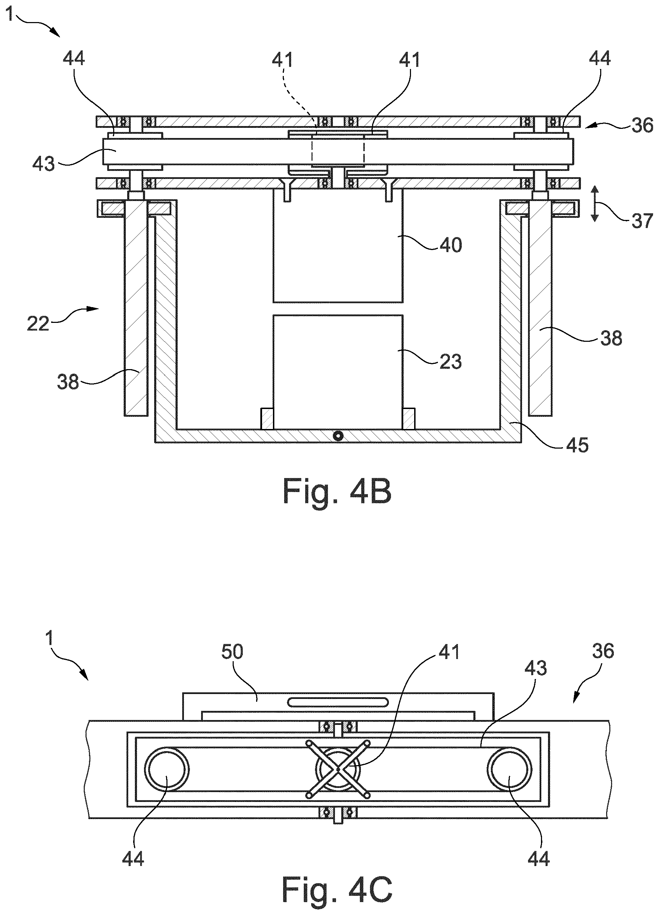

Figur 4B zeigt die Hubvorrichtung 36 in einer Seitenansicht der Rakelvorrichtung 1 und Figur 4C zeigt eine vereinfachte Draufsicht auf die Hubvorrichtung 36.

Die Hubvorrichtung 36 ist als Spindelhubvorrichtung ausgebildet, die gemäß dem vorliegenden Ausführungsbeispiel zwei Hubspindeln 38 aufweist, die jeweils durch ein Gewinde eines Trägers 45 der Antriebseinrichtung 22 geführt sind, sodass bei einer Drehung der jeweiligen Hubspindel 38 die Antriebseinrichtung translatorisch beziehungsweise axial entlang der Hubspindel 38 verfahren wird. Zum Antreiben der Hubspindel 38 ist insbesondere ein Riemenantrieb 39 eingesetzt, der einen Antriebsmotor 40, insbesondere Elektromotor, aufweist, der mit einem Antriebsrad 41 wirkverbunden ist, sowie einen Riemen 43, der um mehrere Führungsrollen 42, von denen bevorzugt zumindest eine als Spannrolle radial elastisch verlagerbar angeordnet ist, sowie um/an den Hubspindeln 38 endseitig befestigte Rollen 44 geführt ist, sodass das Drehmoment des Antriebsmotors 40 durch den Riemen 43 auf die Hubspindeln 38 übertragbar ist. Mithilfe der Hubvorrichtung 36 ist die Antriebseinrichtung 22 mit dem darin angeordneten Rakelwerk 4 somit auf ein Drucksieb oder eine Druckschablone herabfahrbar oder von diesem/dieser ablösbar.

Der Rakelwerkhalter 30 ist an dem Träger 45 der Antriebseinrichtung 22 verschwenkbar gehalten. Dazu weist der Rakelwerkhalter 30 an zwei voneinander abgewandten Stirnseiten jeweils einen Lagerbolzen 46 auf, der in einer Lageraufnahme 47 des Trägers 45 drehbar gelagert einliegt. Dadurch ist der gesamte Rakelwerkhalter 30 um eine Achse verschwenkbar gelagert, die insbesondere, wie in Figur 4A gezeigt, eine Mittelachse 48 ist und sich insbesondere parallel zu den Drehachsen der Wellen 10, 11 erstreckt. Dabei schneidet die Mittelachse 48 insbesondere die Mittellängsachse der Schneckenwelle 16. Durch das Verschwenken des Rakelwerkhalters 30 wird auch das Rakelwerk 4, das durch die Rastmittel 27 damit verbunden ist, verschwenkt und mit dem Rakelwerk die Rakelklingen 5, 6. Hierdurch ist eine optimale Rakelwinkeleinstellung im Druckbetrieb gewährleistet.

Zum Verschwenken des Rakelwerkhalters 30 ist zumindest ein pneumatischer Aktuator 49 vorhanden, wie beispielhaft in Figuren 1 und 4A gezeigt. Der Rakelwerkhalter 30 weist zwei voneinander abgewandte Vorsprünge 50 auf, die jeweils an den sich parallel zur Mittelachse 48 erstreckenden Längsseiten des Rakelwerkhalters angeordnet sind und seitlich vorstehen, sodass sich eine L-Form ergibt. Diesen Vorsprüngen ist gemäß dem vorliegenden Ausführungsbeispiel jeweils ein pneumatischer Aktuator 49 zugeordnet. Jeder der pneumatischen Aktuatoren weist einen Pneumatikkolben 51 auf, der mit dem Vorsprung 50 zusammenwirkt und insbesondere tangential zur Mittelachse 48 in einem Pneumatikzylinder verschiebbar gelagert ist. Durch das Ansteuern der Aktuatoren ist der Rakelwerkhalter 30 und damit das Rakelwerk 4 gezielt verschwenkbar um die Mittelachse 48.

Durch die pneumatische Kraftaufbringung auf den Rakelwerkhalter 30 ist gewährleistet, dass durch das Pneumatikmedium eine Elastizität geboten ist, die ein Verschwenken des Rakelwerkhalters 30 entgegen der Aktuierungsrichtung ermöglicht. Dadurch kann beispielsweise das Rakelwerk 4 entgegen der Kraft des Aktuators 49 verschwenkt werden, wenn eine der Rakelklingen 5 oder 6 auf einen unüberwindbaren Gegenstand trifft. Dadurch können die Rakelklingen 5, 6 geschont und eine hohe Lebensdauer für das Rakelwerk 4 garantiert werden.

## Patentansprüche

1. Rakelwerk (4) für eine Druckvorrichtung (2) zum Bedrucken von flächigen Substraten, insbesondere Leiterplatten, Wafer oder Solarzellen, mit zwei Rakelklingen (5,6) die sich parallel zueinander erstrecken und verschwenkbar gelagert sind, **dadurch gekennzeichnet, dass** die Rakelklingen (5,6) mit einem Getriebe (35) und durch das Getriebe (35) miteinander wirkverbunden sind, das als Schneckenradgetriebe selbsthemmend ausgebildet und mit einer Antriebseinrichtung (22) koppelbar oder gekoppelt ist.

2. Rakelwerk nach Anspruch 1, **dadurch gekennzeichnet, dass** die Rakelklingen (5,6) durch das Getriebe (35) in eine V-förmige Transportstellung verschwenkbar sind, in welcher die Rakelklingen (5,6) an ihren freien Rakelwirkkanten (7,8) aneinander anliegen.

3. Rakelwerk nach einem der vorhergehenden Ansprüche, **dadurch gekennzeichnet, dass** jede Rakelklinge (5,6) an jeweils einer drehbar gelagerten Welle (10,11) zum Verschwenken angeordnet ist, wobei auf jeder der Wellen (10,11) ein Schneckenrad (14,15) drehfest angeordnet ist, das in Eingriff mit einer mit der Antriebseinrichtung (22) verbundenen oder verbindbaren Schneckenwelle (16) steht.

4. Rakelwerk nach einem der vorhergehenden Ansprüche, **dadurch gekennzeichnet, dass** das Getriebe (35) eine Antriebswelle (37) aufweist, die einerseits mit der Schneckenwelle (16) gekoppelt ist und andererseits ein Koppelende (19) aufweist, das zur lösbaren Kopplung der Antriebswelle (17) mit der Antriebseinrichtung (22) ausgebildet ist, wobei dass das Koppelende (19) insbesondere als Bestandteil einer formschlüssigen oder reibschlüssigen Kupplung (26) ausgebildet ist.

5. Rakelwerk nach einem der vorhergehenden Ansprüche, **dadurch gekennzeichnet, dass** es ein Gehäuse (18) aufweist, in oder an welchem das Getriebe (35), der Rakelträger (9) und die Rakelklingen (5,6) gehalten sind, wobei die Antriebswelle (17) durch eine Öffnung des Gehäuses (18) nach außen geführt ist.

6. Rakelwerk nach einem der vorhergehenden Ansprüche, **dadurch gekennzeichnet, dass** das Rakelwerk (4) Mittel (27), insbesondere Rastmittel, zur lösbaren Befestigung an der Antriebseinrichtung (22) aufweist.

7. Rakelvorrichtung (1) für eine Druckvorrichtung (2) zum Bedrucken von flächigen Substraten, insbesondere Leiterplatten, Wafer oder Solarzellen, mit einem Rakelwerk (4) und einer Antriebseinrichtung (22) für das Rakelwerk (4), **gekennzeichnet durch** die Ausbildung des Rakelwerks (4) nach einem der Ansprüche 1 bis 6.

8. Rakelvorrichtung nach Anspruch 7, **dadurch gekennzeichnet, dass** die Antriebseinrichtung (22) eine Elektromaschine (23) aufweist, die mit dem Getriebe (35) koppelbar ist.

9. Rakelvorrichtung nach einem der vorhergehenden Ansprüche, **dadurch gekennzeichnet, dass** die Antriebseinrichtung (22) eine Abtriebswelle (24) aufweist, die ein mit dem Getriebe (35) gekoppeltes oder koppelbares Ende (25) aufweist, wobei das Ende (25) der Abtriebswelle (24) insbesondere zur lösbaren Kopplung mit der Antriebswelle (17) des Getriebes (35) ausgebildet ist.

10. Rakelvorrichtung nach einem der vorhergehenden Ansprüche, **dadurch gekennzeichnet, dass** die Antriebseinrichtung (22) einen Rakelwerkhalter (30) aufweist, der lösbar mit dem Rakelwerk (4) verbindbar ist.

11. Rakelvorrichtung nach einem der vorhergehenden Ansprüche, **dadurch gekennzeichnet, dass** die Mittel (27) zumindest ein elastisch verformbares oder verlagerbares Rastelement (28) aufweisen.

12. Rakelvorrichtung nach einem der vorhergehenden Ansprüche, **dadurch gekennzeichnet, dass** der Rakelwerkhalter (30) um eine sich parallel zu den Wellen (10,11) erstreckende Mittelachse (48) verschwenkbar gelagert ist.

13. Rakelvorrichtung nach einem der vorhergehenden Ansprüche, **dadurch gekennzeichnet, dass** dem Rakelwerkhalter (30) an zumindest einem von der Mittelachse (48) entfernten Vorsprung (50) ein ansteuerbarer Aktuator (49) zum Verschwenken des Rakelwerkhalters (30) zugeordnet ist.

14. Rakelvorrichtung nach einem der vorhergehenden Ansprüche, **dadurch gekennzeichnet, dass** der Aktuator (49) als pneumatischer Aktuator (49) mit einem dem Vorsprung (50) zugeordneten Hubkolben (51) ausgebildet ist, der insbesondere tangential zur Mittelachse (48) verlagerbar ist.

15. Druckvorrichtung zum Bedrucken von flächigen Substraten, insbesondere Leiterplatten, Wafer oder Solarzellen, mit einer Rakelvorrichtung (1), mit einem Drucksiebhalter, an welchem ein Drucksieb oder eine Druckschablone oder -maske anordenbar oder angeordnet ist, und mit einem Drucktisch, auf welchem das Substrat auf der von der Rakelvorrichtung gegenüberliegenden Seite des Drucksiebhalters anordenbar ist, **gekennzeichnet durch** die Ausbildung der Rakelvorrichtung (1) nach einem der Ansprüche 7 bis 14.

## Claims

1. Doctoring unit (4) for a printing apparatus (2) for printing on flat substrates, in particular circuit boards, wafers, or solar cells, having two doctoring blades (5, 6) which extend parallel to one another and are pivotably mounted, **characterised in that** the doctoring blades (5, 6) are operatively connected to a gearing (35) and to one another by the gearing (35), which is configured as a self-locking worm gearing and can be coupled or is coupled to a drive device (22).

2. Doctoring unit according to claim 1, **characterised in that** the doctoring blades (5, 6) are pivotable by the gearing (35) into a V-shaped transport position, in which the doctoring blades (5, 6) lie against each other at their free doctoring edges (7, 8).

3. Doctoring unit according to one of the preceding claims, **characterised in that** each doctoring blade (5, 6) is arranged on a respective rotatably mounted shaft (10, 11) for pivoting, wherein a worm gear (14, 15) is arranged on each of the shafts (10, 11) in a rotationally fixed manner, which worm gear (14, 15) is in engagement with a worm shaft (16) connected or connectable to the drive device (22).

4. Doctoring unit according to one of the preceding claims, **characterised in that** the gearing (35) comprises a drive shaft (37) which is coupled on the one hand to the worm shaft (16) and on the other hand has a coupling end (19) which is configured for releasable coupling of the drive shaft (17) to the drive device (22), wherein the coupling end (19) is configured in particular as a component of a positive-locking or frictionally engaging coupling (26).

5. Doctoring unit according to one of the preceding claims, **characterised in that** it comprises a housing (18) in or on which the gearing (35), the doctoring carrier (9) and the doctor blades (5, 6) are held, wherein the drive shaft (17) is guided outwards through an opening in the housing (18).

6. Doctoring unit according to one of the preceding claims, **characterised in that** the doctoring unit (4) comprises means (27), in particular latching means, for detachable attachment to the drive device (22).

7. Doctoring apparatus (1) for a printing apparatus (2) for printing on flat substrates, in particular circuit boards, wafers, or solar cells, having a doctoring unit (4) and a drive device (22) for the doctoring unit (4), **characterised by** the configuration of the doctoring unit (4) according to one of the claims 1 to 6.

8. Doctoring apparatus according to claim 7, **characterised in that** the drive device (22) comprises an electric motor (23) which can be coupled to the gearing (35).

9. Doctoring apparatus according to one of the preceding claims, **characterised in that** the drive device (22) comprises an output shaft (24) which comprises an end (25) coupled or couplable to the gearing (35), wherein the end (25) of the output shaft (24) is configured in particular for releasable coupling to the drive shaft (17) of the gearing (35).

10. Doctoring apparatus according to one of the preceding claims, **characterised in that** the drive device (22) comprises a doctoring unit holder (30) which is releasably connectable to the doctor unit (4).

11. Doctoring apparatus according to one of the preceding claims, **characterised in that** the means (27) comprise at least one elastically deformable or displaceable latching element (28).

12. Doctoring apparatus according to one of the preceding claims, **characterised in that** the doctoring unit holder (30) is pivotably mounted about a central axis (48) extending parallel to the shafts (10, 11).

13. Doctoring apparatus according to one of the preceding claims, **characterised in that** a controllable actuator (49) for pivoting the doctoring unit holder (30) is associated with the doctoring unit holder (30) on at least one projection (50) away from the central axis (48).

14. Doctoring apparatus according to one of the preceding claims, **characterised in that** the actuator (49) is configured as a pneumatic actuator (49) having a reciprocating piston (51) associated with the projection (50), which in particular can be displaced tangentially to the central axis (48).

15. Printing apparatus for printing on flat substrates, in particular circuit boards, wafers, or solar cells, having a doctor apparatus (1), having a printing screen holder, on which a printing screen or a printing stencil or printing mask can be arranged or is arranged, and having a printing table, on which the substrate can be arranged on the side of the printing screen holder opposite the doctoring apparatus, **characterised by** the configuration of the doctoring apparatus (1) according to one of the claims 7 to 14.

## Revendications

1. Mécanisme de râclage (4) pour un dispositif d'impression (2) destiné à imprimer des substrats plats, en particulier des cartes de circuits imprimés, des plaquettes ou des cellules solaires, avec deux lames de râclage (5, 6) qui s'étendent parallèlement l'une à l'autre et qui sont logées de manière à pouvoir pivoter, **caractérisé en ce que** les lames de râclage (5, 6) sont reliées activement entre elles à un engrenage (35) et à travers l'engrenage (35) qui est conçu de manière autobloquante comme engrenage à vis sans fin et peut être accouplé ou qui est accouplé à un dispositif d'entraînement (22).

2. Mécanisme de râclage selon la revendication 1, **caractérisé en ce que** les lames de râclage (5, 6) peuvent être pivotées par l'engrenage (35) dans une position de transport en forme de V, dans laquelle les lames de râclage (5, 6) s'appuient l'une contre l'autre par leurs bords actifs de râclage libres (7, 8).

3. Mécanisme de râclage selon l'une des revendications précédentes, **caractérisé en ce que** chaque lame de râclage (5, 6) est disposée sur un arbre respectif (10, 11) monté rotatif pour le pivotement, une roue à vis sans fin (14, 15) étant disposée solidairement en rotation sur chacun des arbres (10, 11) et étant en prise avec un arbre à vis sans fin (16) relié ou pouvant être relié au dispositif d'entraînement (22).

4. Mécanisme de râclage selon l'une des revendications précédentes, **caractérisé en ce que** le mécanisme (35) présente un arbre d'entraînement (37) qui, d'une part, est accouplé à l'arbre à vis sans fin (16) et, d'autre part, présente une extrémité d'accouplement (19) qui est conçue pour l'accouplement amovible de l'arbre d'entraînement (17) avec le dispositif d'entraînement (22), l'extrémité d'accouplement (19) étant conçue en particulier comme élément d'un accouplement (26) à coopération de forme ou de friction.

5. Mécanisme de râclage selon l'une des revendications précédentes, **caractérisé en ce qu'il** présente un boîtier (18) dans ou sur lequel sont maintenus l'engrenage (35), le support de râclage (9) et les lames de râclage (5, 6), l'arbre d'entraînement (17) étant guidé vers l'extérieur à travers une ouverture du boîtier (18).

6. Mécanisme de râclage selon l'une des revendications précédentes, **caractérisé en ce que** le mécanisme de râclage (4) présente des moyens (27), en particulier des moyens d'encliquetage, pour une fixation amovible sur le dispositif d'entraînement (22).

7. Dispositif de râclage (1) pour un dispositif d'impression (2) destiné à imprimer des substrats plats, en particulier des cartes de circuits imprimés, des plaquettes ou des cellules solaires, comprenant un mécanisme de râclage (4) et un dispositif d'entraînement (22) pour le mécanisme de râclage (4), **caractérisé par** la réalisation du mécanisme de râclage (4) selon l'une des revendications 1 à 6.

8. Dispositif de râclage selon la revendication 7, **caractérisé en ce que** le dispositif d'entraînement (22) présente une machine électrique (23) qui peut être couplée à la transmission (35).

9. Dispositif de râclage selon l'une quelconque des revendications précédentes, **caractérisé en ce que** le dispositif d'entraînement (22) comporte un arbre de sortie (24) présentant une extrémité (25) accouplée ou pouvant être accouplée à la transmission (35), l'extrémité (25) de l'arbre de sortie (24) étant notamment configurée pour être accouplée de manière amovible à l'arbre d'entraînement (17) de la transmission (35).

10. Dispositif de râclage selon l'une des revendications précédentes, **caractérisé en ce que** le dispositif d'entraînement (22) comporte un support de mécanisme de râclage (30) qui peut être relié de manière amovible au mécanisme de râclage (4).

11. Dispositif de râclage selon l'une des revendications précédentes, **caractérisé en ce que** les moyens (27) comportent au moins un élément d'encliquetage (28) élastiquement déformable ou déplaçable.

12. Dispositif de râclage selon l'une des revendications précédentes, **caractérisé en ce que** le support de mécanisme de râclage (30) est monté pivotant autour d'un axe central (48) s'étendant parallèlement aux arbres (10, 11).

13. Dispositif de râclage selon l'une des revendications précédentes, **caractérisé en ce qu'**un actionneur (49) pouvant être commandé est associé au support de mécanisme de râclage (30) sur au moins une saillie (50) éloignée de l'axe central (48) pour faire pivoter le support de mécanisme de râclage (30).

14. Dispositif de râclage selon l'une des revendications précédentes, **caractérisé en ce que** l'actionneur (49) est conçu comme un actionneur pneumatique (49) avec un piston de levage (51) associé à la saillie (50), qui peut être déplacé en particulier tangentiellement à l'axe central (48).

15. Dispositif d'impression pour imprimer des substrats plats, en particulier des cartes de circuits imprimés, des plaquettes ou des cellules solaires, comprenant un dispositif de râclage (1), un support d'écran d'impression sur lequel un écran d'impression ou un pochoir ou un masque d'impression peut être disposé ou est disposé, et une table d'impression sur laquelle le substrat peut être disposé sur le côté du support d'écran d'impression opposé au dispositif de râclage, **caractérisé par** la réalisation du dispositif de râclage (1) selon l'une des revendications 7 à 14.
